Europäisches Patentamt

European Patent Office

Office européen des brevets

(19)

(11) Veröffentlichungsnummer: **0 300 215**
**A2**

## EUROPÄISCHE PATENTANMELDUNG

(21) Anmeldenummer: **88109968.3**

(22) Anmeldetag: **23.06.88**

(51) Int. Cl.⁴: **C04B 35/00 , H01L 39/24 , C22C 1/05 , C22C 29/12 , B22F 7/08**

(30) Priorität: **22.07.87 DE 3724229**

(43) Veröffentlichungstag der Anmeldung:
**25.01.89 Patentblatt 89/04**

(84) Benannte Vertragsstaaten:
**CH DE FR GB IT LI NL**

(71) Anmelder: **Batteile-Institut e.V.**
**Am Römerhof 35 Postfach 900 160**
**D-6000 Frankfurt/Main 90(DE)**

(72) Erfinder: **Heide, Helmut, Dr.**
**Am Hohenstein 14**
**D-6233 Kelkheim(DE)**
Erfinder: **Winter, Heinrich, Dr.**
**Kurt-Schumacher-Strasse 4**
**D-6236 Eschborn(DE)**

(74) Vertreter: **Sartorius, Peter, Dipl.-Ing.**
**Batteile-Institut e.V. Abteilung Patente Am Römerhof 35**
**D-6000 Frankfurt am Main 90(DE)**

(54) Verfahren zur Herstellung eines duktilen Verbundwerkstoffs aus einem Hochtemperatur-Supraleiter.

(57) Beschrieben wird ein Verfahren zur Herstellung eines duktilen Verbundwerkstoffs aus einem spröden Hochtemperatur-Supraleiter auf der Basis von sauerstoffdefekten Mischoxiden mit Perowskitstruktur. Erfindungsgemäß wird aus dem spröden Mischoxid feinkörniges Pulver hergestellt, das in ein duktiles Metall mit guter elektrischer Leitfähigkeit und möglichst geringer Affinität zu dem Mischoxid eingelagert wird.

EP 0 300 215 A2

## Verfahren zur Herstellung eines duktilen Verbundwerkstoffs aus einem Hochtemperatur-Supraleiter

Die Erfindung betrifft ein Verfahren zur Herstellung eines duktilen Verbundwerkstoffs aus einem spröden Hochtemperatur-Supraleiter auf der Basis von sauerstoffdefekten Mischoxiden mit Perowskitstruktur im System SE-EA-Cu-O, wobei SE seltene Erdmetalle und EA Erdalkalimetalle sind.

Soweit bekannt gibt es bis heute noch kein Verfahren, mit dem sich ein duktiler Verbundwerkstoff aus dem erwähnten Hochtemperatur-Supraleiter herstellen läßt. An derartigen Verbundwerkstoffen besteht aber ein großer Bedarf, wenn man die großen Vorteile der erst kürzlich entdeckten Hochtemperatur-Supraleiter nutzen will.

Die von Bednorz und Müller entdeckten und in der Folgezeit von einer großen Anzahl von Wissenschaftlern weiterentwickelten Supraleiter auf der Basis von spröden sauerstoffdefekten Mischoxiden mit Perowskitstruktur im System SE-EA-Cu-O mit SE für seltene Erdmetalle und EA für Erd. alkalimetalle etwa der Zusammensetzung $Y Ba_2Cu_3O_{6,5}$ erreichen Sprungtemperaturen bis über $100\,^{\circ}K$ und können daher mit flüssigem Stickstoff betrieben werden. Vgl. Bednorz, J.G.; Müller, K.A.: Possible High Tc Superconductivity in the Ba-La-Cu-O-System. Condensed matter, Zeitschrift für Physik 64 (1986), 189-193.

Diese Hochtemperatur-Supraleiter sind außerordentlich spröde und können daher nicht zu langgestreckten Teilen wie Draht mit einer ausreichenden Stromtragfähigkeit von mindestens $10^4 A/cm^2$ verarbeitet werden. Weiterhin sind diese neuartigen oxidischen Supraleiter außerordentlich empfindlich gegen verschiedene Gase und Dämpfe, insbesondere gegen Wasserdampf, und verlieren in einer solchen Atmosphäre rasch ihre guten Eigenschaften.

Der Erfindung liegt daher die Aufgabe zugrunde, ein Verfahren vorzuschlagen, mit dem es gelingt, einen duktilen Verbundwerkstoff aus einem spröden Hochtemperatur-Supraleiter der eingangs genannten Art vorzuschlagen. Mit dem erfindungsgemäßen Verfahren sollen die erwähnten spröden und empfindlichen Supraleiter technisch nutzbar gemacht werden können, ohne daß diese in ihren guten supraleitenden Eigenschaften dabei beeinträchtigt werden. Neben der Duktilisierung soll auch eine dauerhafte Versiegelung der erwähnten spröden Hochtemperatur-Supraleiter erzielt werden.

Zur Lösung dieser Aufgabe ist die Erfindung dadurch gekennzeichnet, daß aus dem spröden Mischoxid feinkörniges Pulver hergestellt wird, das in ein duktiles Metall mit guter elektrischer Leitfähigkeit und möglichst geringer Affinität zu dem Mischoxid eingelagert wird.

Die Anteile an dargegebenen Metall wird man so wählen, daß einerseits die gewünschten Eigenschaften erhalten werden, insbesondere Duktilität und Supraleitung, und andererseits nicht mehr duktiles Metall als notwendig zugegeben wird, und zwar dies insbesondere aus Kostengründen, weil sich als duktiles Metall Silber oder Kupfer besonders gut eignet.

Es ist daher der Grundgedanke der Erfindung, diese etwa in Form spröder Pellets vorliegenden supraleitenden Mischoxide zu äußerst feinkörnigem Pulver zu verarbeiten und diese extrem kleinen Pulverteilchen gleichmäßig in eine metallische Matrix einzulagern, welche nicht oder nur in geringfügigem Maße mit dem Supraleiter reagiert und diesen vor schädlichen Gasen und Dämpfen wirksam schützt, dergestalt, daß der resultierende Verbundwerkstoff duktil wird und zugleich gute supraleitende Eigensschaften aufweist, welche bei einem genügend kleinen Abstand der supraleitenden Teilchen aufgrund des Proximity Effektes und des Tunneleffektes erreichbar sind.

Dieser Grundgedanke läßt sich erfindungsgemäß realisieren indem man die spröden supraleitenden Pellets etwa durch Mahlen in einer Hochgeschwindigkeits-Kugelmühle in einer absolut wasserfreien Atmosphäre und Absieben zur gewünschten Kornfraktion von weniger als 50 $\mu$m, insbesondere aber von weniger als 15 $\mu$m verarbeitet. Im Anschluß daran werden diese sehr feinen supraleitenden Teilchen in eine duktile Matrix mit einer guten elektrischen und thermischen Leitfähigkeit, wie Silber oder auch Kupfer, eingelagert. Silber reagiert auch bei Temperaturen über $450\,^{\circ}C$ nicht mit den supraleitenden Pulverteilchen und zeigt zudem keine große Affinität zum Sauerstoff. Es stört damit nicht das empfindliche Sauerstoffgleichgewicht in den sauerstoffdefekten supralietenden Oxiden. Die Verwendung von Kupfer als Matrixmetall erfordert die Einhaltung eines Temperaturlimits von etwa $300\,^{\circ}C$ im Herstellungsprozeß. Hier empfiehlt es sich, oberflächlich oxidierte Pulverteilchen zur Stabilisierung der supraleitenden Teilchen zu verwenden, deren Oberfläche sich im Gleichgewicht mit dem Supraleiter befindet.

Die Einlagerung der feinen supraleitenden Teilchen in die metallische Matrix kann auf zwei Wegen erfolgen. Einerseits kann man die supraleitenden Teilchen mit den sehr feinen, insbesondere durch Fällungsreaktionen oder thermische Zersetzung gewonnenen Metallpulver mit einer Korngröße von weniger als 5 $\mu$m mischen und zu Formkörpern verpressen. Andererseits kann man die supraleitenden Teilchen aus der Gasphase, z.B. mit Hilfe der Chemical Vapor- oder des Physical Vapor Deposition Verfahrens (CVD oder PVD Verfahren) mit dem Matrixmetall beschichten. Die Beschichtung aus einem Elektrolyten kann nur unter völliger Abwesenheit von Wasser, also in einem aprotischen Elektrolyten, z.B. stromlos, erfolgen.

Nach der Weiterverarbeitung der Pulver durch Pressen, insbesondere durch kaltisostatisches und/oder heißisostatisches Pressen (CIP und/oder HIP) oder aber auch durch Sprengverdichten, werden die resultierenden etwa zylindrischen Blöcke durch Strangpressen und/oder Rundhämmern und/oder Profilwalzen und/oder Ziehen zu langgestreckten Körpern wie Draht verarbeitet. Das auf diese Weise hergestellte Halbzeug weist ein dichtes und porenfreies Gefüge auf und ist bis zu einem Volumenanteil an supraleitenden Teilchen von maximal etwa 80% ausreichend duktil. Obwohl sich die einzelnen supraleitenden Teilchen in der Metallmatrix kaum berühren, so wird doch der Verbundwerkstoff bei genügend kleinem Teilchenabstand aufgrund des Proximity-Effekts und bei extrem kleinem Abstand aufgrund des Tunneleffekts zum Supraleiter. Dieser zeigt die für die sauerstoffdefekten Mischoxide, wie $Y_1Ba_2Cu_3O_{6,5}$ charakteristischen hohen Sprungtemperaturen und eine wesentlich gesteigerte kritische Stromdichte in der Größenordnung von $10^4 A/cm^2$ bei der Temperatur des flüssigen Stickstoffs.

Besonders gute elektrische und mechanische Eigenschaften des supraleitenden Verbundwerkstoffs können erreicht werden, wenn man ein Rohr aus einem Metall, wie Kupfer, mit vorgepreßten und durch CIP und/oder HIP (kaltisostatisches und/oder heißisostatisches Pressen) aber auch durch Sprengstoff verdichteten Formkörpern füllt und durch Strangpressen und/oder Rundhämmern und/oder Profilwalzen und/oder Ziehen zu dünnen Rohren oder Drähten verarbeitet, welche aus einem supraleitenden Kern mit einem duktilen Schutzmantel etwa aus Kupfer bestehen. Sehr wichtig ist es, daß durch den Kupfermantel nicht nur der supraleitende Kern von Gasen und Dämpfen sicher geschützt ist, sondern daß durch den Kupfermantel die elektrische Eigenstabilität des supraleitenden Verbundwerkstoffs wesentlich gesteigert wird, da bei einem lokalen Zurückfallen von Teilbereichen des supraleitenden Kerns in den normalleitenden Zustand die Unterbrechungsstelle durch den Kupfermantel überbrückt wird.

Dünne supraleitende Schichten können durch Aufbringen eines Lacks aus einer Suspension von feinen supraleitenden Oxidteilchen und sehr feinen Metallpulvern etwa des Silbers oder Kupfers in einem wasserfreien organischen Lösungsmittel oder Öl, insbesondere mit einem Zusatz eines organischen Binders, hergestellt werden. Nach dem Trocknen dieses Lacks liegen die supraleitenden Teilchen in einer Matrix aus feinsten Teilchen, z.B. aus Silber oder Kupfer eingebettet, welche trotz des organischen Binders eine gute elektrische Leitfähigkeit aufweist. Durch kontinuierliches Aufbringen dieses Lacks auf Bänder oder Rohre, etwa aus Kupfer, lassen sich sehr lange supraleitende Stromleitungen herstellen.

Im Falle von außenbeschichteten Rohren können diese durch Zirkulieren des Kühlmittels, etwa aus flüssigem Stickstoff, im Rohrinneren gekühlt werden. Diese Rohre werden vorteilhafterweise mit einem wärmeisolierendem Mantel versehen. Sehr wichtig ist ferner, daß durch das etwa aus Kupfer bestehende Rohr die elektrische Eigenstabilität des supraleitenden Verbundes erheblich gesteigert wird.

Als Alternative zum Mischen von Supraleiterpulvern auf der Basis von sauerstoffdefekten Mischoxiden mit Metallpulvern etwa aus Silber oder Kupfer und Verpressen des Gemischs können die supraleitenden Teilchen mit dem Matrixmetall beschichtet werden. Dieses kann durch CVD-(Chemical Vapor Deposition) oder PVD-Verfahren (Physical Vapor Deposition) etwa im Wirbelbettverfahren geschehen. Auch kann die Abscheidung des Matrixmetalls aus einem wasserfreien, sogenannten aprotischen Elektrolyten, insbesondere stromlos, in Erwägung gezogen werden. Die Weiterverarbeitung dieses Pulvers kann dann in der bereits beschriebenen Weise vorgenommen werden.

Beispiel

Herstellung eines Drahtes oder Rohres mit einem supraleitenden Kern und einem Kupfermantel

Pellets aus spröder $Y_1Ba_2Cu_3O_{6,5}$ Keramik werden in einer Hochgeschwindigkeits-Kugelmühle zu Feinstpulver verarbeitet und eine Kornfraktion mit einer Korngröße von weniger als 7,7 μm durch Sieben abgetrennt: Dies geschieht in einer völlig wasserfreien Atmosphäre mit Anteilen an Sauerstoff wie Luft oder Argon mit ca. 20% Sauerstoff. Das erhaltene Pulver wird mit einem insbesondere oberflächenoxidierten Kupfer- oder Silberpulver einer Korngröße von weniger als 3 μm im Gewichtsanteil von 45% an Kupferteilchen oder 55% an Silberteilchen gründlich vermischt und mit einem Druck von 3 kbar zu Tabletten mit einem Durchmesser von 30mm und einer Dicke von 10 mm verpreßt, welche im Anschluß daran heißisostatisch bei einer Temperatur von 600°C während einer Stunde unter einem Druck von 2 - 3 kbar dicht gepreßt werden.

Der resultierende zylindrische Formkörper mit einem Durchmesser von knapp 30 mm und einer Höhe von ca. 100 mm wird dann in ein weiches Kupferrohr mit einer Wandstärke von 10 mm und einem Außendurchmesser von 50 mm eingepaßt und das Rohr beidseitig geschlossen und evakuiert. Dieser Strangpreßbolzen wird dann in einem Zug bis auf einen Durchmesser von 15 mm stranggepreßt und im Anschluß daran durch Profilwalzen auf einen Durchmesser von 5 mm gebracht, abschließend zu einem Draht mit einem Durchmesser von 2 mm gezogen und etwa 1 h unter trockener Luft bei 700° C wärmebehandelt.

Der resultierende Verbundwerkstoff mit einem supraleitenden Kern und einem Kupfermantel zeigt eine Sprungtemperatur von 97 K und eine Stromtragfähigkeit von $3 \times 10^4$ A/cm². Er ist ohne Beeinträchtigung seiner supraleitenden Eigenschaften biegsam und duktil und kann zu supraleitenden Spulen gewickelt werden.

**Ansprüche**

1. Verfahren zur Herstellung eines duktilen und stabilen keramischen Hochtemperatursupraleiters auf der Basis von sauerstoffdefekten Mischoxiden mit Perowskitstruktur, etwa von $Y \cdot Ba_2Cu_3O_{7-x}$ mit $x \leq 0,5$,

**gekennzeichnet durch**
die folgenden Verfahrensschritte:

a) Herstellung eines möglichst phasenreinen Mischoxides und Zerteilung zu einem Pulver mit einer Korngröße von weniger als 15 μm in einer sehr trockenen, sauerstoffhaltigen Atmosphäre,

b) Herstellung eines Metallpulvers mit einer Korngröße von weniger als 5 μm aus Kupfer und/oder Silber,

c) Zusatz von Oxiden oder Bildung von Oxiden auf der Oberfläche des Metallpulvers zur Stabilisierung der supraleitenden Mischoxidpulver bei der Konsolidierung zu Formkörpern,

d) Herstellung eines Gemisches aus dem supraleitenden Keramikpulver einerseits und dem oberflächenoxidierten Metallpulver und/oder dem sauerstoffabgebenden Metalloxid andererseits,

e) Konsolidierung des Gemisches nach d) durch Vorpressen und anschließendes heißisostatisches Pressen oder durch Sprengkompaktieren,

f) Einlagerung der konsolidierten Formkörper nach e) in ein Kupferrohr und anschließendes Umformen zu langgestreckten Formkörpern.

2. Verfahren nach Anspruch 1,
**dadurch gekennzeichnet,**
daß in der Verfahrensstufe d) zwischen 15 und 35 Vol.-%, vorzugsweise zwischen 20 und 30 Vol.-%, Metallpulver und/oder Metalloxidpulver, dem Keramikpulver zugemischt werden.

3. Verfahren nach Anspruch 1 oder 2,
**dadurch gekennzeichnet,**
daß in dem Formkörper der Anteil des Metalls kleiner ist als etwa 35 Vol.%, vorzugsweise kleiner als etwa 30 Vol.% und größer als etwa 15 Vol.%, vorzugsweise größer als etwa 20 Vol.%.

4. Verfahren nach einem der Ansprüche 1 bis 3,
**dadurch gekennzeichnet,**
daß als duktiles Metall Kupfer und/oder Silber verwendet wird.

5. Verfahren nach einem der Ansprüche 1 bis 4,
**dadurch gekennzeichnet,**
daß Pulver mit einer Korngröße von weniger als 50 μm, vorzugsweise weniger als 15 μm, verwendet wird.

6. Verfahren nach einem der Ansprüche 1 bis 5,
**dadurch gekennzeichnet,**
daß das Mischoxid durch Mahlen hergestellt wird.

7. Verfahren nach Anspruch 6,
**dadurch gekennzeichnet,**
daß das Mahlen in einer sauerstoffhaltigen und sehr trockene Atmosphäre erfolgt.

8. Verfahren nach einem der Ansprüche 1 bis 7,
**dadurch gekennzeichnet,**
daß die Einlagerung der feinkörnigen supraleitenden Teilchen in die metallische Matrix durch Mischen mit sehr feinkörnigem Metallpulver mit einer Korngröße von weniger als etwa 5 μm und anschließende Konsolidierung zu dichten Formkörpern erfolgt.

9. Verfahren nach einem der Ansprüche 1 bis 7,
**dadurch gekennzeichnet,**
daß die Einlagerung der feinkörnigen supraleitenden Pulverteilchen in die metallische Matrix durch Belegung, beispielsweise Bedampfen, dieser Teilchen mit einer Schicht aus dem Matrixmetall und anschließender Konsolidierung zu dichten Formkörpern erfolgt.

10. Verfahren nach Anspruch 8 oder 9,
**dadurch gekennzeichnet,**
daß zur Stabilisierung der supraleitenden Teilchen bei der Konsolidierung zu dichten Formkörpern dem Metallpulver oder den mit Metall belegten supraleitenden Teilchen Oxide, insbesondere des Matrixmetalls, zugesetzt oder durch Oberflächenoxidation erzeugt werden.

11. Verfahren nach einem der Ansprüche 8 bis 10,
**dadurch gekennzeichnet,**
daß die Konsolidierung durch Vorpressen und anschließendes Kaltpressen und/oder heißisostatisches Pressen erfolgt.

12. Verfahren nach Anspruch 11,

**dadurch gekennzeichnet,**

daß der konsolidierte Formkörper anschließend durch Strangpressen und/oder Rundhämmern und/oder Walzen und/oder Ziehen zu einem langgestreckten Formkörper, wie Profil oder Draht verarbeitet wird.

13. Verfahren nach einem der Ansprüche 8 bis 10,

**dadurch gekennzeichnet,**

daß die Konsolidierung durch Vorpressen und anschließendes Sprengkompaktieren durchgeführt wird.

14. Verfahren nach einem der Ansprüche 8 bis 10,

**dadurch gekennzeichnet,**

daß die Konsolidierung durch Anpasten des Gemisches mit einem organischen Lösungsmittel, insbesondere mit Zusatz eines organischen Binders, erfolgt, das anschließend verdampft.

15. Verfahren nach einem der Ansprüche 8 bis 14,

**dadurch gekennzeichnet,**

daß zur Herstellung eigenstabiler supraleitender Rohre oder Drähte das vorgepreßte Pulvergemisch insbesondere durch kalt- und/oder heißisostatisches Pressen verdichtet und in ein Schutzrohr, insbesondere aus reinem Kupfer, eingeschlossen wird, welches anschließend, insbesondere durch die in Anspruch 11 beschriebenen Verfahren, zu langgestreckten Rohren oder Drähten verarbeitet wird, welche aus einem supraleitenden Kern und einem duktilen elektrisch gut leitfähigem Metall als Schutzmantel bestehen, der die Eigenstabilität des Supraleiters erhöht.

16. Verfahren nach Anspruch 14,

**dadurch gekennzeichnet,**

daß zur Herstellung dünner supraleitender Schichten das Gemisch aus supraleitenden Teilchen und Metallpulver oder die mit Metall belegten supraleitenden Teilchen mit wasserfreien organischen Lösungsmitteln und einem organischen Binder zu einem Lack verarbeitet werden, der nach dem Trocknen einen festen, dünnen, biegsamen supraleitenden Überzug bildet.

17. Verfahren nach Anspruch 16,

**dadurch gekennzeichnet,**

daß die äußere Oberfläche eines Kupferrohres mit dem supraleitenden Lack belegt wird und das Rohr zum Transport des Kühlmittelsfür den Supraleiter, wie flüssigem Stickstoff, genutzt wird.